# EUROPEAN PATENT SPECIFICATION

(11) **EP 1 708 318 B1**
(45) Date of publication and mention of the grant of the patent: **13.10.2010**
(21) Application number: 05255084.5
(22) Date of filing: 17.08.2005
(51) Int. Cl.: H01S 1/02

(54) **Quantum cascade laser**
Quantenkaskadenlaser
Laser à cascade quantique

(30) Priority: 28.03.2005 JP 2005091412
(43) Date of publication of application: 04.10.2006
(73) Proprietor: National Institute of Information and Communications Technology Incorporated Administrative Agency, Koganei-shi, Tokyo (JP)
(72) Inventor: Yasuda, Hiroaki, Nat. Inst. of Inf. and Comm. Tech, Koganei-shi Tokyo (JP); Hosako, Iwao, Nat. Inst. of Inf. and Comm. Tech, Koganei-shi Tokyo (JP)
(74) Representative: Smith, Norman Ian

(56) References cited:
- US-B1- 6 404 791
- YANG R Q: "Infrared laser based on intersubband transitions in quantum wells" SUPERLATTICES AND MICROSTRUCTURES UK, vol. 17, no. 1, 1995, pages 77-83, XP007900076 ISSN: 0749-6036
- HILL C J ET AL: "MBE growth optimization of Sb-based interband cascade lasers" JOURNAL OF CRYSTAL GROWTH, ELSEVIER, AMSTERDAM, NL, vol. 278, no. 1-4, 4 February 2005 (2005-02-04), pages 167-172, XP004857791 ISSN: 0022-0248
- WILLIAMS BENJAMIN S ET AL: "3.4-THz quantum cascade laser based on longitudinal-optical-phonon scattering for depopulation" APPLIED PHYSICS LETTERS, AIP, AMERICAN INSTITUTE OF PHYSICS, MELVILLE, NY, US, vol. 82, no. 7, 17 February 2003 (2003-02-17), pages 1015-1017, XP012034783 ISSN: 0003-6951
- WILLIAMS B S ET AL: "Resonant-phonon terahertz quantum-cascade laser operating at 2.1 THz (lambda≃141 m)" ELECTRONICS LETTERS, IEE STEVENAGE, GB, vol. 40, no. 7, 1 April 2004 (2004-04-01), pages 431-433, XP006021752 ISSN: 0013-5194

## Description

### BACKGROUND +OF THE INVENTION

### Field of the Invention:

This invention relates to a quantum cascade laser that lases in the terahertz range.

### Description of the Prior Art:

The terahertz range (1-10 THz) is a set of frequencies that are intermediate between those of infrared rays and microwave rays. This range has seen only limited utilization owing to the strong absorption of terahertz radiation by the earth's atmosphere and the lack of a small solid-state signal source. In 1994, however, the situation began to change with the invention of the quantum cascade laser (QCL), a device that makes use of inter-subband electron transition in the multi-quantum well structure of compound semiconductors. The device had a lasing frequency in the near-infrared range. Then, in 2002, development of a terahertz range QCL was reported that has since drawn attention as a small solid-state signal source usable in the terahertz range.

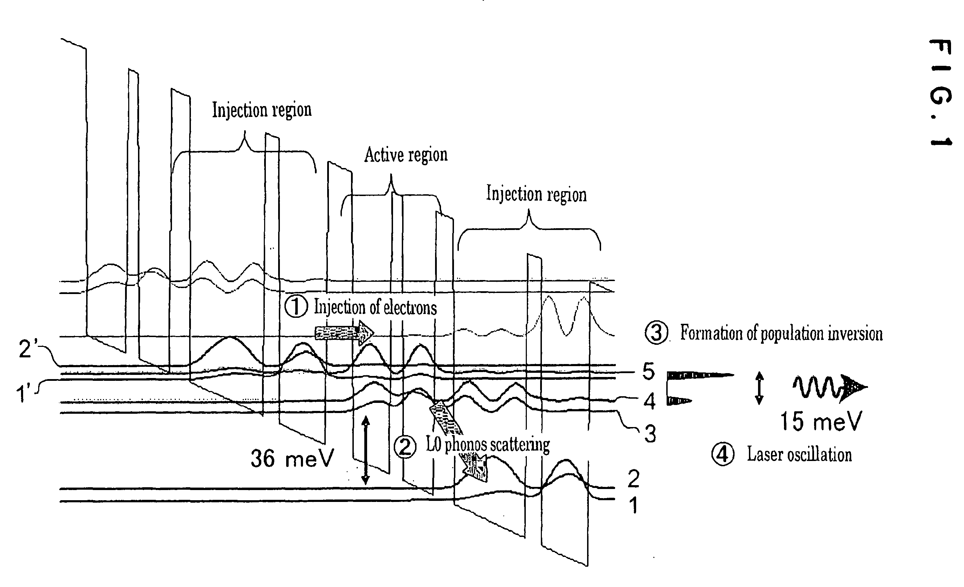

One example of a QCL is discussed in B.S Williams, et al., "3.4 THz quantum cascade laser based on longitudinal-optical phonon scattering for depopulation," Applied Physics Letters, 82: 1015 (2003). This QCL has an AlGaAs/GaAs multi-quantum well structure that utilizes phonon scattering. Lasing is achieved by using the longitudinal-optical (LO) phonon scattering of GaAs to form a population inversion of electrons between the subbands. In the case of GaAs having an LO phonon energy of 36 meV, the frequency is around 3 THz As shown in FIG 1, the QCL is composed of repeating basic multi-quantum well structures. The basic multi-quantum well structure described in the paper of Williams et al. can be represented as 5.4/7.8/2.4/6.5/3.8/14.9/3.0/9.5 nm, where the underlined layers are barriers composed of Al_{0.15}Ga_{0.85}As and the layers that are not underlined are wells composed of GaAs. The GaAs layer of 14.9 nm thickness is n-type doped at the level of 1.9 x 10¹⁶ per cubic centimeter.

A brief explanation of the operating principle of the QCL follows. The subband state of the QCL's multi-quantum well structure can be determined by solving the Schroedinger and Poisson equations self-consistently. FIG 1 shows the subband state of the conduction bands of two basic multi-quantum well structures under an applied electric field of 12.0 kV/cm. As shown in FIG 1, each basic multi-quantum well structure is divided into an injection region and an active region. First, electrons are injected from the state 2' or 1' of the injection region into the excited state n = 5 of the active region. Next, in the active region, the injected electrons transit from the excited state n = 5 to the ground states n = 4 or 3 while emitting terahertz radiation. The frequency of the radiation is determined by the energy difference between the excited state and the ground state. The energy difference between the state n = 4 or 3 and the state n = 2 is designed to have almost the same value as the longitudinal-optical (LO) phonon energy of the material composing the well. The phonon energy of GaAs, for example, is 36 meV Electrons in the state n = 4 or 3 are therefore scattered by the LO phonons into the state n = 2 to decrease the number of electrons in state n = 4 or 3. The resulting population inversion is realized between the state n = 5 and the state n = 4 or 3. Then, laser oscillation originates. The laser frequency is designed to be 3.6 THz (15 meV).

However, in the case where the electric field strength is lower than the value used in FIG 1 (12.0 kV/cm), the energy of the state n = 4 becomes higher than those of the states n = 1' and 2', so that the lasing process described above cannot be established and no lasing occurs.

B.S Williams, et al. have also reported a quantum cascade laser having a structure similar to the one mentioned in which the thicknesses are 5.6/8.2/3.1/7.0/4.2/16.0/3.4/9.6 nm, where the underlined layers are AlGaAs layers and the layers that are not underlined are GaAs layers (B. S. Williams, et al., Electronics Letters. Volume: 40 Issue: 7 Page 431). The thickness of the barrier at the center of the active layer is 3.1 nm and the energy difference between state 5 and state 4 is 9.0 meV to achieve 2.1 THz lasing. The barrier is 0.6 nm or a mere two atom layers thicker than that in the structure reported above, and the wells next to the barrier are a mere 0.4 and 0.5 nm thicker.

However, the foregoing two examples have the following restriction and problems.

In these examples, the thickness of the wells and barriers in the active region is less than 10 nm. The monolayer thickness of GaAs and AlGaAs is around 0.3 nm. The thickness distribution of the formed layers therefore needs to be made small. This restricts design freedom.

Moreover, the electric field strength at the start of lasing is around 12 kV/cm, which is relatively high. As a result, a large number of hot electrons and hot phonons are generated, so that deviation from the designed operation may arise and high heat generation occurs that tends to degrade the laser.

Further, these QCLs are generally fabricated using a molecular beam epitaxy (MBE) machine. Since the MBE-grown layer thickness becomes more than 10 µm, undulations and layers are apt to undulate and cause local electric field concentration. When this happens, lasing occurs at the sites of high electric field concentration, while at other locations no lasing occurs but rather the produced terahertz radiation is absorbed. The laser power may be weakened as a result.

In order to form the necessary superlattice, semiconductor layers of greater thickness are used. In addition, the electric field strength at the start of lasing is set lower so as to curb degradation of the laser by abnormal operation and heat generation owing to the generation of hot electrons and hot phonons.

The present invention makes it possible to realize a quantum cascade laser having a lower lasing frequency and an easier structure to fabricate than conventional quantum cascade lasers.
QCLs made of GaSb material system have been reported by R. Q. Yang, in US-B1-6,.404,791 (YANG RUI Q) 11 June 2002 (2002-6-11) and YANG R Q: "Infrared laser based on intersubband transitions in quantum wells" SUPERLATTICES AND MICROSTRUCTURES UK, vol. 17, No 1, 1995, pages 77-83. The reported typical QCL has an InAs/AlSb/GaSb multi-quantum well structure. This structure is a so-called type II heterostructure, because the valence band edge of GaSb is higher than the conduction band edge of InAs. However, these QCLs utilized the intersubband transition in the conduction band of the InAs layer, or the interband transition from a subband on the conduction band of the InAs layer to a subband of the valence band of the GaSb layer. The present invention differs from those, because the invention utilizes the intersubband transition in the conduction band of the GaSb layer and the population inversion generated by LO phonon scatterings of GaSb as we will explain later.

### SUMMARY OF THE INVENTION

According to the present invention there is provided an intersubband quantum cascade laser comprising a superlattice having electrode layers formed at opposite ends thereof, the superlattice comprising alternating quantum well layers of GaSb and barrier layers of AISb or GaAlSb, the superlattice comprising a plurality of identical repeating units, each repeating unit comprising an active region and an injection region, characterised in:
that the thickness of one of the quantum wells of the injection region is adjusted such that in said quantum well the energy difference formed between the ground state and the first excited state becomes equal to the longitudinal optical phonon energy of GaSb.

In one embodiment, the superlattice device has as a repeating unit an AlSb layer, a GaSb layer, an AlSb layer, a GaSb layer, an AlSb layer, an n-type GaSb layer, an AISb layer and a GaSb layer, a plurality of such units being sandwiched between two n-type semiconductor layers used as contact layers.

A structure in which the AlSb layers are replaced by GaAlSb also functions as a quantum cascade laser.

Terahertz radiation containment can be effectively achieved by forming the quantum cascade laser on a superlattice buffer.

Formation of the quantum cascade laser on a GaAs substrate through an intervening buffer layer permits a reference beam to be irradiated through the GaAs substrate.

The quantum cascade laser can be used for synchronized lasing. In this case, the potential difference required for lasing is applied across the electrodes and a reference beam is shined on the superlattice region.

### BRIEF EXPLANATION OF THE DRAWINGS

FIG. 1 is a schematic diagram showing the energy band structure of a quantum cascade laser.

FIG 2 is a schematic diagram showing the energy band structure of a quantum cascade laser embodying the invention.

FIG 3 is an overview showing steps in the process of fabricating a quantum cascade laser embodying the invention.

FIG 4(a) is a sectional view of a quantum cascade laser embodying this invention.

FIG. 4(b) is a perspective view of the quantum cascade laser of FIG 4(a).

FIG 5 is a diagram showing the setup in the case of injection locking.

### DESCRIPTION OF THE PREFERRED EMBODIMENT

An embodiment of the invention will now be explained in detail with reference to the drawings. An embodiment of the quantum cascade laser of this invention will first be explained with reference to Table 1 below.

**Table 1**

| No. | | Material | Thickness (nm) | Te concentration (cm⁻³) |
|---|---|---|---|---|
| 1 | | n-GaSb (contact layer) | 60 | 5.00E+18 |
| 2 | ↑ | QCL structure | (1 module: 80.1 nm x 200 times) | |
| | 200 repetitions | AlSb | 4.3 | |
| | | GaSb | 14.4 | |
| | | AlSb | 2.4 | |
| | | GaSb | 11.4 | |
| | | AlSb | 3.8 | |
| | | n-GaSb | 24.6 | 1.90E+16 |
| | | AlSb | 3 | |
| | ↓ | GaSb | 16.2 | |
| 3 | | n-GaSb (contact layer) | 800 | 3.00E+18 |
| 4 | ↑ 20 repe | Superlattice buffer | (1 module: 5 nm x 20 times) | |
| | ↓ titions | GaSb | 2.5 | |
| | | AlSb | 2.5 | |
| 5 | | Buffer | | |
| | | GaSb buffer | 1000 | |
| | | AlSb buffer | 100 | |
| | | AlAs buffer | 10 | |
| | | GaAs buffer | 100 | |
| | | Semi-insulating GaAs substrate | | |

As shown in Table 1 above, a semi-insulating GaAs substrate is used as the semiconductor substrate. Buffer layers, for example layers of GaAs (100 nm), AlAs (10 nm), AlSb (100 nm) and GaSb (1000 nm), are successively formed on the substrate using a molecular beam epitaxy (MBE) machine. Further, twenty 2.5 nm AlSb layers and twenty 2.5 nm GaSb layers are alternately formed as additional buffer layers. Next, a first contact layer composed of n+ GaSb doped with n-type impurity at, for example, 3 x 10¹⁸/cm³ is formed to a thickness of about 800 nm. Next, a basic multi-quantum well structure composed of, in top-down order, of 4.3/14.4/2.4/11.4/3.8/24.6/3.0/16.2 nm layers, where the underlined layers are barriers composed of AlSb and the layers that are not underlined are wells composed of GaSb, is formed. The structure thus has a 16.2 nm GaSb layer on its substrate side. The GaSb layer of 24.6 nm thickness is n-type doped at the level of 1.9 x 10¹⁶/cm³. Electrons are supplied from this n-type layer and scattering occurs. This basic multi-quantum well structure is repeatedly formed 200 times, for example. A second contact layer composed of GaSb doped with n-type impurity at, for example, 5 x 10¹⁸/cm³ is then formed to a thickness of, for instance, 60 nm. The compound semiconductors following the buffer layers are also formed using an MBE machine.

Antimony-based compound semiconductors such as GaSb tend to disperse on the surface during MBE growth. Surface irregularities can therefore be suppressed to minimize electric field concentration when voltage is applied. The laser beam is therefore more uniformly generated and the laser intensity increases because the terahertz radiation is not readily absorbed at places other than the electric field concentration sites.

The fabrication process of the QCL having the foregoing structure will now be explained.

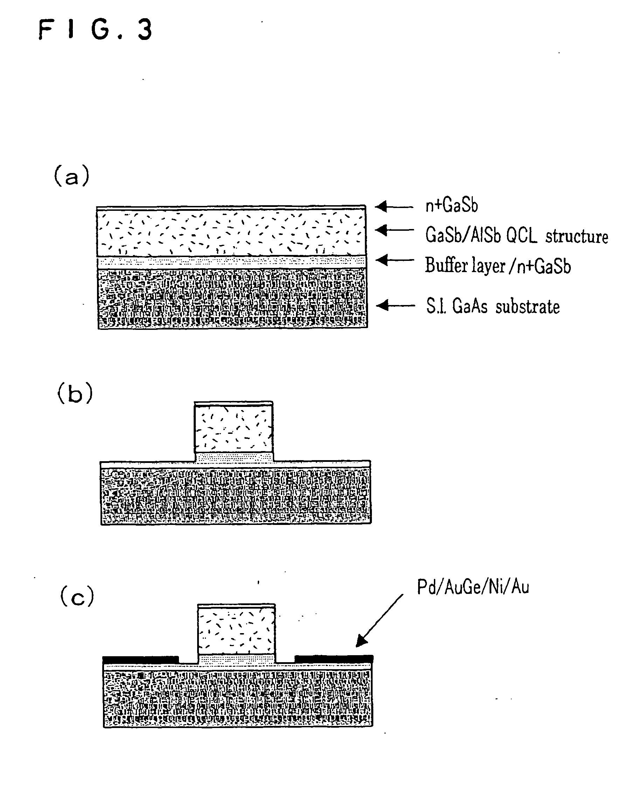

1) In FIG 3, the upper diagram (a) shows a partial sectional view of the wafer immediately after MBE growth. First, the resist on the portions to become the ridge structures of the QCL are selectively allowed to remain.

2) Then, using the resist as a mask, the multi-quantum well structure is removed by reactive ion etching (RIE) using SiCl₄, for example, to selectively expose the first contact layer.

3) After removal of the resist ((b) in FIG 3), a metal layer of, for example Pd/AuGe/Ni/Au is selectively formed on the exposed first contact layer by the liftoff method. A sectional view of the structure at this stage of fabrication is shown at (c) in FIG 3.

4) Annealing is then conducted at, for example, 300°C for one minute.

5) Next, a metallic layer of, for example, Pd/Au is selectively overlaid on the upper surface of the mesa structure formed by RIE, i.e., on the second contact layer, by the liftoff method.

6) The wafer is then cleaved to form a resonator of approximately 2 mm length. The width of the ridge structure is in the approximate range of 100 µm to 200 µm.

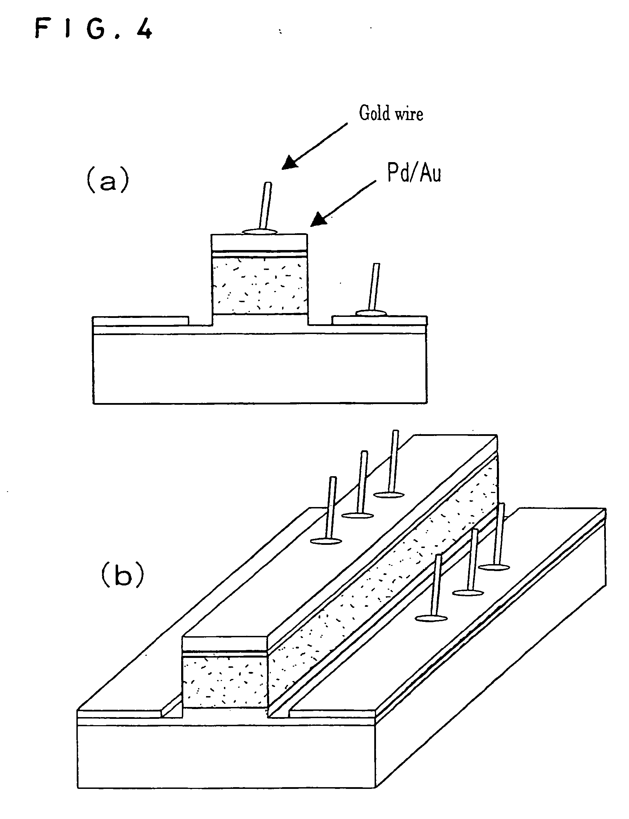

7) Gold wires are attached to the electrodes on the first contact layer and the second contact layer, thereby forming two leads. FIG 4(a) and 4(b) are a sectional view and a perspective view of the structure at this stage of fabrication.

8) The so-fabricated device is operated by applying a voltage across the leads, i.e., across the electrodes. If necessary, the QCL is cooled with liquid nitrogen or liquid helium and a pulsed voltage is applied.

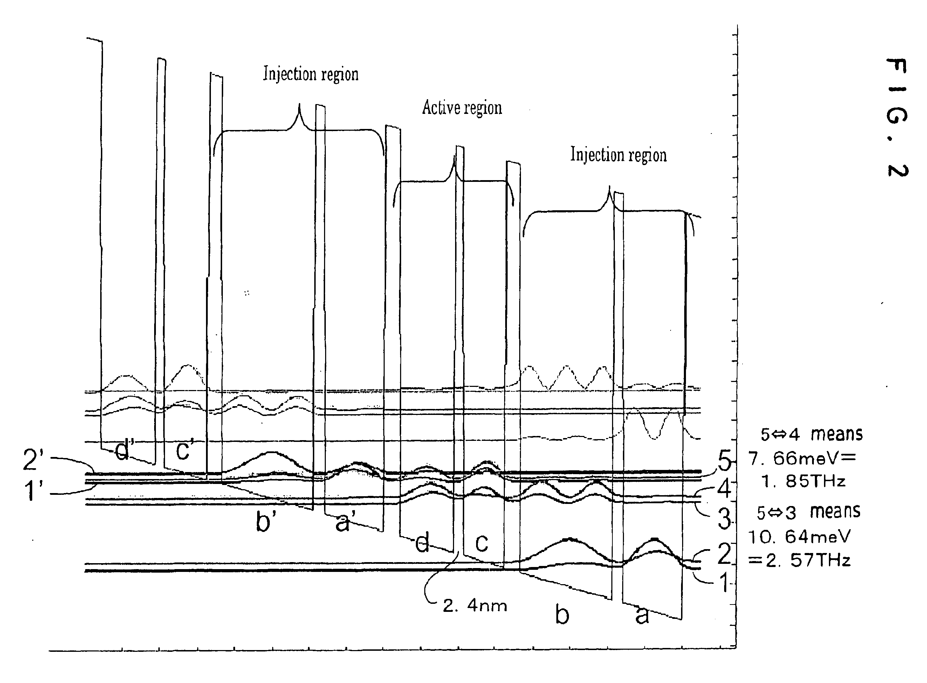

FIG 2 shows the subbands in the conduction band for two basic structure units of the QCL configuration of the foregoing embodiment. Each interval on the vertical axis corresponds to 10 meV and each interval on the horizontal axis to 10 nm. The subbands are determined by solving the Schroedinger and Poisson equations self-consistently in one dimension. In FIG 2, the subbands are represented as what is obtained by multiplying the probability density in the state, i.e. the square of the wave function, by an appropriate multiple for convenience of representation and adding the product to the energy in the state. The sum of the subband probability density is normalized to 1. The wells *a*, *b*, *c* and *d* are GaSb layers having thicknesses of 16.2 nm, 24.6 nm, 11.4 nm and 14.4 nm, respectively. The electric field strength in FIG 2 is 5.45 kV/cm, which is less than half the value in FIG 1. The energy difference between state 5 and state 4 is 7.66 meV, corresponding to 1.85 THz, and the energy difference between state 5 and state 3 is 10.64 meV, corresponding to 2.57 THz. Thus, the QCL of this embodiment achieves lasing at a lower frequency than the conventional QCL of FIG. 1 notwithstanding that the thickness of the barrier between the well *c* and well *d* is 2.4 nm in both QCLs. Moreover, the QCL of this embodiment enjoys greater design freedom than the conventional QCL owing to the greater thickness of the wells.

The design principles of the QCL structure will now be explained and a preferred structure of the invention QCL described.

First, regarding to the active region, the thicknesses of the well *c*, the well *d* and the barrier therebetween are designed to establish the ground state and the excited state in the well c and the well *d* and make the energy difference between the states approximately equal to the lasing frequency of the QCL at a prescribed lasing electric field strength. So as to make the wave functions of the ground state and excited state present in both the well *c* and the well *d*, the ground state wave function is made to arise chiefly from the well *d* and the excited state wave function is made to arise chiefly from the well *c*. In other words, the well *c* is made narrower than the well d.

Next, regarding the injection region, LO phonon scattering of electrons from state 4 or 3 to state 2 or 1 is necessary in FIG 2. For this, the thickness of the well *b* is defined so that at a prescribed electric field strength, e.g., at the electric field strength at which lasing starts, the energy difference between the ground state and the excited state in the well *b* becomes equal to the LO phonon energy of GaSb. The phonon energy of GaSb is around 28.9 meV and is thus characterized in being smaller than in the conventional QCL.

Further, at the prescribed electric field strength, for efficient extraction of the phonon-scattered electrons from the well *b* into the well *a*, the thickness of the well *a* and the thickness of the barrier between the wells *a* and *b* are defined so that, as shown in FIG 2, the ground state energy of the well *b* and the ground state energy of the well *a* are about the same. In light of the fact that the ground state energy increases with decreasing well thickness, the well *a* is made thinner than the well *b*.

Further, regarding the relationship between the active region and the injection region, efficient injection of electrons from the well a' into the first excited state of the well *d* or well *c* is enabled by making the energy levels of the injection region ground state and the active region first excited state about the same at a prescribed electric field strength, thereby coupling their wave functions.

In addition, efficient extraction of electrons from the ground state of the active region at the prescribed electric field strength is enabled, i.e., coupling of the ground state of the well *c* or well *d* with the first excited state in the well *b* is established. The thicknesses of the well *c* and well *d* are made about half that of the thickness of the well *b*.

As can be seen from the foregoing conditions, the electric field strength and the well and barrier thicknesses are regulated and calculation repeated. From this it can be seen that the sum of the thickness of the well a'*,* well *c* and well *d* is made not greater than twice the thickness of the well *b.*

Further, when the prescribed electric field strength is applied, there must arise in each basic unit of the QCL a potential difference approximately the same as the energy sum of an energy difference between the excited state and the ground state in the injection region, i.e., the LO phonon energy and an energy difference between the excited state and ground state energies in the active region, i.e., the energy corresponding to the lasing frequency. As explained in the foregoing, the thickness of the wells *a* to *d* are substantially defined, so that this condition must be met by varying the electric field strength. Therefore, by making the LO phonon energy small as in this invention, it is possible to lower the electric field strength at which lasing starts.

Moreover, when the LO phonon energy is small as in this invention, the width of the well *b* becomes large so that the thickness of the other wells and barriers can be made large. Further, owing to the fact that the effective mass of GaSb is 0.0412 and smaller than the effective mass of 0.67 of GaAs, the use of GaSb as in this invention enables the width of the wells to be made larger. As a result, the effect that a thickness fluctuation of one atom layer has on laser performance, e.g, the lasing frequency, is small. MBE growth is therefore easier because the allowable range of film thickness during film growth by MBE becomes greater.

In addition, use of the aforesaid antimony-based MBE growth minimizes surface undulations to enable increase in laser power.

This invention thus increases the degree of design freedom and enables lowering of the lasing frequency.

Although use of AlSb for the barrier layers is exemplified in the foregoing embodiment, no reason exists for limiting the compound to AlSb and any of various other compounds that constitute a barrier with respect to GaSb and readily form a superlattice structure can be used instead. For example, there can be used GaₓAl₁₋ₓSb (where x is a value between 0 and 1). Moreover, since AlSb layers or GaAISb layers can be used as barriers, mixed use thereof is also possible.

The invention can utilize a waveguide of surface plasmon mode structure on one side. However, the invention is not limited to this type of waveguide and can use a metal-metal waveguide instead. In addition, containment of the generated terahertz radiation within the QCL structure can be achieved by providing contact layers of high impurity concentration above and below the QCL structure so as to control the refraction index. However, the invention is not limited to this arrangement and it is obviously possible to provide a layer having a low index of refraction instead.

Synchronous lasing of the QCL can be achieved by injection of a reference beam as follows.

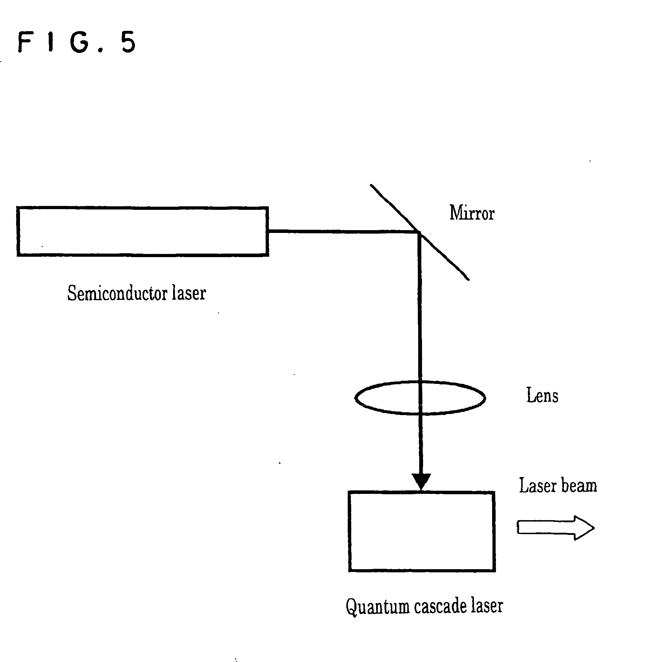

When, for example, it is desired to lock the lasing frequency of the QCL by injection of a semiconductor laser beam in the 1.5 micron band (injection locking), a pulsed laser beam is injected using the configuration shown in FIG 5. In the case of the foregoing embodiment, however, the semiconductor laser beam would be reflected because the upper electrode of the QCL is made of gold or other metal. On the other hand, injection locking by use of a 1.5 micron laser, for example, is impossible when the substrate of the QCL is made of GaSb because GaSb absorbs radiation up to the long wavelength side. In contrast, when a substrate, such as a GaAs substrate, as in the foregoing embodiment is used, such absorption does not occur, whereby it becomes possible to achieve injection locking of the QCL from the rear of the substrate, for example, using a 1.5 micron band semiconductor laser. It should be noted, however, that the semiconductor laser beam can be injected not only from the substrate side but also through the side faces of the ridge structures or from above if the electrodes of the QCL are made from a transparent material such as iridium-tin-oxide (ITO).

## Claims

1. An intersubband quantum cascade laser comprising a superlattice having electrode layers formed at opposite ends thereof, the superlattice comprising alternating quantum well layers (a, b, c, d,) of GaSb and barrier layers of AlSb or GaAlSb, the superlattice comprising a plurality of identical repeating units, each repeating unit comprising an active region and an injection region, **characterized in:**
**that** the thickness of one of the quantum wells (b) of the injection region is adjusted such that in said quantum well (b) the energy difference formed between the ground state and the first excited state becomes equal to the longitudinal optical phonon energy of GaSb.

2. An intersubband quantum cascade laser according to claim 1, **characterized in:**
**that** the superlattice has as a repeating unit an AlSb layer, a GaSb layer, an AlSb layer, a GaSb layer, an AISb layer, an n-type GaSb layer, an AISb layer and a GaSb layer and
**that** a plurality of such units are sandwiched between two n-type semiconductor layers used as contact layers.

3. An intersubband quantum cascade laser according to claim 1, **characterized in:**
**that** the superlattice has as a repeating unit a GaAlSb layer, a GaSb layer, a GaAlSb layer, a GaSb layer, a GaAISb layer, an n-type GaSb layer, a GaAlSb layer and a GaSb layer, and
**that** a plurality of such units are sandwiched between two n-type semiconductor layers used as contact layers.

4. An intersubband quantum cascade laser according to claim 2 or claim 3, **characterized in:**
**that** the laser is formed on a substrate through an intervening superlattice buffer layer.

5. An intersubband quantum cascade laser according to claim 4, **characterized in:**
**that** the substrate is a GaAs substrate.

6. A laser arrangement comprising an intersubband quantum cascade laser according to any one of claims 2 to 5 and means for applying a potential difference required for lasing across the contact layers and means for irradiating the superlattice with a reference beam.

7. A method of operating an intersubband quantum cascade laser according to any one of claims 2 to 5 comprising the steps of applying a potential difference required for lasing across the contact layers and irradiating the superlattice with a reference beam.

8. An intersubband quantum cascade laser according to any one of claims 2 to 5 comprising an electric power supply unit for applying a potential difference between the electrode layers.

## Patentansprüche

1. Ein Intersubbandquantenkaskadenlaser, umfassend ein Übergitter mit Elektrodenschichten, die an entgegengesetzten Enden davon ausgebildet sind, wobei das Übergitter alternierend Quantenschachtschichten (a, b, c, d) aus GaSb sowie Barriereschichten aus AlSb oder GaAlSb aufweist, während das Übergitter eine Mehrzahl identischer Wiederholeinheiten umfasst, wobei jede Wiederholeinheit eine aktive Region und eine Injektionsregion umfasst, **dadurch gekennzeichnet, dass:**
die Dicke von einem der Quantenschächte (b) der Injektionsregion so angepasst ist, dass in dem Quantenschacht (b) die Energiedifferenz, die zwischen dem Grundzustand und dem ersten angeregten Zustand ausgebildet ist, gleich der längsgerichteten optischen Phononenergie von GaSb wird.

2. Ein Intersubbandquantenkaskadenlaser gemäß Anspruch 1, **dadurch gekennzeichnet, dass** das Übergitter als eine Wiederholeinheit eine AlSb-Schicht, eine GaSb-Schicht, eine AlSb-Schicht, eine GaSb-Schicht, eine AlSb-Schicht, eine GaSb-Schicht vom n-Typ, eine AlSb-Schicht sowie eine GaSb-Schicht aufweist, und dass
eine Mehrzahl von solchen Einheiten zwischen zwei Halbleiterschichten vom n-Typ angeordnet ist, die als Kontaktschichten verwendet werden.

3. Ein Intersubbandquantenkaskadenlaser gemäß Anspruch 1, **dadurch gekennzeichnet, dass** das Übergitter als eine Wiederholeinheit eine GaAlSb-Schicht, eine GaSb-Schicht, eine GaAlSb-Schicht, eine GaSb-Schicht, eine GaAlSb-Schicht, eine GaSb-Schicht vom n-Typ, eine GaAlSb-Schicht sowie eine GaSb-Schicht aufweist, und dass
eine Mehrzahl von solchen Einheiten zwischen zwei Halbleiterschichten vom n-Typ angeordnet ist, die als Kontaktschichten verwendet werden.

4. Ein Intersubbandquantenkaskadenlaser gemäß Anspruch 2 oder Anspruch 3, **dadurch gekennzeichnet, dass**
der Laser auf einem Substrat durch eine zwischen geordnete Übergitterpufferschicht ausgebildet ist.

5. Ein Intersubbandquantenkaskadenlaser gemäß Anspruch 4, **dadurch gekennzeichnet, dass** das Substrat ein GaAs-Substrat ist.

6. Eine Laseranordnung umfassend einen Intersubbandquantenkaskadenlaser gemäß einem der Ansprüche 2 bis 5 sowie Mittel zum Anwenden einer Potenzialdifferenz, die zum Lasern über die Kontaktschichten erforderlich ist, und Mittel zum Bestrahlen des Übergitters mit einem Referenzstrahl.

7. Ein Verfahren zum Betreiben eines Intersubbandquantenkaskadenlasers gemäß einem der Ansprüche 2 bis 5, umfassend die Schritte: Anwenden einer Potenzialdifferenz, die zum Lasern über die Kontaktschichten erforderlich ist, und Bestrahlen des Übergitters mit einem Referenzstrahl.

8. Ein Intersubbandquantenkaskadenlaser gemäß einem der Ansprüche 2 bis 5, umfassend eine elektrische Energieversorgungseinheit zum Anwenden einer Potenzialdifferenz zwischen den Elektrodenschichten.

## Revendications

1. Laser à cascade quantique à inter-subbande comprenant un réseau superposé ayant des couches d'électrodes formées à ses extrémités opposées, le réseau superposé comprenant des couches de puits quantique alternantes (a, b, c, d) de GaSb et des couches barrière de AlSb ou GaAlSb, le réseau superposé comprenant plusieurs unités de répétition identiques, chaque unité de répétition comprenant une région active et une région d'injection, **caractérisé**
**en ce que** l'épaisseur d'un des puits quantiques (b) de la région d'injection est ajustée de façon que dans ledit puits quantité (b), la différence d'énergie formée entre l'état de masse et le premier état excité devient égale à l'énergie de phonons optiques longitudinaux de GaSb.

2. Laser à cascade quantique à inter-subbande selon la revendication 1, **caractérisé en ce que**:
le réseau superposé comporte comme unité de répétition une couche AlSb, une couche GaSb, une couche AlSb, une couche GaSb, une couche AlSb, une couche GaSb de type-n, une couche AlSb et une couche GaSb; et
**en ce que** plusieurs de ces unités sont prises en sandwich entre deux couches semi-conductrices de type-n utilisées comme couches de contact.

3. Laser à cascade quantique à inter-subbande selon la revendication 1, **caractérisé en ce que**:
le réseau superposé possède comme unité de répétition une couche GaAlSb, une couche GaSb, une couche GaAlSb, une couche GaSb, une couche GaAlSb, une couche GaSb de type-n, une couche GaAlSb et une couche GaSb, et
**en ce que** plusieurs de ces unités sont prises en sandwich entre deux couches semi-conductrices de type-n utilisées comme couches de contact.

4. Laser à cascade quantique à inter-subbande selon la revendication 2 ou la revendication 3, **caractérisé en ce que**:
le laser est formé sur un substrat par une couche tampon de réseau superposé intervenante.

5. Laser à cascade quantique à inter-subbande selon la revendication 4, **caractérisé en ce que** le substrat est un substrat GaAs.

6. Agencement laser comprenant un laser à cascade quantique à inter-subbande selon l'une quelconque des revendications 2 à 5 et des moyens pour appliquer une différence de potentiel requise pour l'émission laser sur les couches de contact et des moyens pour irradier le réseau superposé avec un faisceau de référence.

7. Procédé de fonctionnement d'un laser à cascade quantique à inter-subbande selon l'une quelconque des revendications 2 à 5, comprenant les étapes consistant à appliquer une différence de potentiel requise pour l'émission laser sur les couches de contact et pour irradier le réseau superposé avec un faisceau de référence.

8. Laser à cascade quantique à inter-subbande selon l'une quelconque des revendications 2 à 5, comprenant une unité d'alimentation électrique pour appliquer une différence de potentiel entre les couches d'électrodes.
